# EUROPEAN PATENT APPLICATION

(11) **EP 1 635 460 A1**
(43) Date of publication of application: **15.03.2006**
(21) Application number: 04745493.9
(22) Date of filing: 26.05.2004
(51) Int. Cl.: H03H 9/25, H01L 23/00

(54) **PIEZOELECTRIC DEVICE**

(30) Priority: 29.05.2003 JP 2003152299; 09.12.2003 JP 2003409796
(71) Applicant: Toyo Communication Equipment Co., Ltd., Kawasaki-Shi, Kanagawa 212-8513 (JP)
(72) Inventor: NAGASHIMA, Ryota, Toyo Communication Equip.Co.Ltd., Kouza-gun, Kanagawa 253-0192 (JP)
(74) Representative: GROSSE BOCKHORNI SCHUMACHER
(86) International application number: PCT/JP2004/007530
(87) International publication number: WO 2004/107572

(57) **Abstract**

The present invention is to provide a low-cost piezoelectric device with a CSP structure, particularly, a surface acoustic wave device. Therefore, the invention is directed to a piezoelectric device which includes: a piezoelectric vibrator provided on one principal face thereof with at least an exciting electrode and a bonding pad extending from the exciting electrode; and a flat plate-like printed circuit board having a pad electrode for mounting of the piezoelectric vibrator and a grounding pad arranged on an upper face and an external electrode on a lower face, in which the piezoelectric vibrator is fixed to the upper face of the printed circuit board through a predetermined gap by connecting the bonding pad and the pad electrode via a metal bump, wherein a metal layer having a thickness larger than an opening size of the gap is formed on a whole surface of the upper face of the piezoelectric device.

## Description

### Technical Field

The present invention relates to an improvement in a small-sized, thin, and low-cost piezoelectric device with a CSP structure, and in particular to an improvement in sealing structure for blocking influence on a piezoelectric vibrator from an external environment.

### Background Art

Piezoelectric devices, particularly, surface acoustic wave devices, are widely utilized in a communication field, and since the piezoelectric devices have excellent features such as high performance, size reduction, and mass productivity, they are particularly used in mobile communication devices such as portable phones.

A conventional surface acoustic wave device will be explained below.

For example, published Japanese translation of PCT International Publication for patent application No. H11-510666 (JP11-510666 A) discloses the conventional surface acoustic wave device, and Fig. 7 is a vertical sectional view showing a configuration of a package thereof.

The conventional surface acoustic wave device is provided with a flat base plate (a ceramic wiring board) 151, a device system (a surface acoustic wave chip) 152 which is fixed on an upper face of the base plate 151 via bumps so as to form a predetermined gap therebetween and has an electrically conductive structure (an interdigital electrode) on a lower face thereof, an insulating frame 153 which is arranged annularly so as to surround the electrically conductive structure provided on the lower face of the device system 152, and a surrounding frame 154 (a resin member) for covering a gap between the insulating frame 153 and the base plate 151 from the outside. Flip-chip mounting is performed so that the upper face of the base plate 151 and the lower face of the device system 152 are opposed to each other, and an outside of the gap between the insulating frame 153 and the base plate 151 is covered with the surrounding frame 154. Further, a protective layer 155 which is a metal thin film is coated to cover the upper face and four side faces of the device system 152, a surface of the surrounding frame 154, and an exposed face of the upper face of the base plate 151.

It is desirable for an improvement in reliability of the surface acoustic wave device to coat the protective layer 155 on the surface of the surrounding frame 154 poor in sealing effect in order to maintain, in a predetermined state, the inside of the insulating frame 153 isolated from an external environment by the surrounding frame 154, namely, space atmosphere (vacuum or inert gas) including the electrically conductive structure. However, when the surface acoustic wave device is exposed to the atmosphere in a time period between a forming step for the surrounding frame 154 and a forming step for the protective layer (a vacuum deposition process, a sputtering process, or a CVD process is generally used in a dry process), it is difficult to maintain the space atmosphere including the electrically conductive structure in the predetermined state.

Recently, in response to a demand for further miniaturization of the surface acoustic wave device, a plane area of the base plate 151 has become only slightly larger than that of the device system 152 and a difference between the both members is further becoming smaller. In order to elevate a mass productivity, a surface acoustic wave device is generally manufactured in a batch process. That is, in the batch process, a plurality of surface acoustic wave devices can be obtained by using a base plate base material with a large area where many base plates 151 are connected in a sheet form at small pitches, flip-chip mounting the device systems 152 on respective sections on the base plate base material, applying resin members (serving as the surrounding frames 154) in gaps among the device systems 152 all at once by a screen printing, coating the protective layer 155 on outer faces of the device systems 152 and the surrounding frames 154 on the base plate base material, and then cutting (performing full cut) the protective layer 155, the surrounding frames 154, and the base plate base material at the gaps among the device systems 152 using a dicing machine.

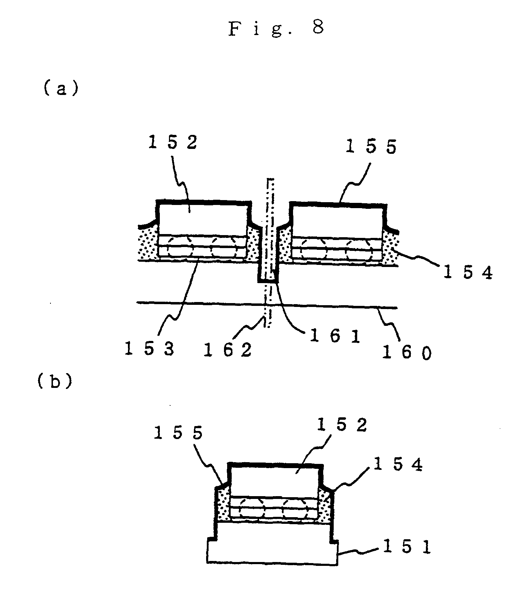

However, in order to cover side faces of the surrounding frame 154 (which constitute side faces of an individuated surface acoustic wave device) and an interface between the surrounding frame 154 and the base plate base material with the protective layer 155, as shown in Fig. 8(a), a groove 161 is formed by cutting the surrounding frame 154 shared by the device systems 152 mounted on the base plate base material 160 and a portion of an upper face of the base plate base material 160 (a first cutting). Thereafter, a protective layer 155 is coated on the upper face of the base plate base material 160 including an inner face (a cut face) of the groove 161, and the protective layer 155 and the remaining half of the base plate base material 160 are cut together at an approximately central portion of the groove 161 using a dicing blade 162 which is thinner than a dicing blade used for the first cutting (a second cutting), so that a plurality of surface acoustic wave devices can be obtained where the side faces of the surrounding frame 154 and the interface between the surrounding frame 154 and the base plate 151 are covered with the protective film 155, as shown in Fig. 8(b). Therefore, the first cutting step must be provided between the second cutting step (corresponding to the full cutting step described above) and the forming step for the protective layer, which complicates the manufacturing step.

Since the gap between the device systems flip-chip mounted on the base plate base material 160 is narrow, it is very difficult to fill a resin member serving as the surrounding frame 164 in the gap by screen printing and to control the process for the screen printing such that the res in member does not enter in the gap between the insulating frame 153 and the base plate base material 160. Therefore, the productivity lowers and it is difficult to achieve a low cost.

In the conventional art, there is a problem that a low-cost piezoelectric device with a CSP structure, particularly, a surface acoustic wave device can not be provided.

### DISCLOSURE OF THE INVENTION

In order to solve the above problem, according to the invention described in claim 1, there is provided a piezoelectric device including: a piezoelectric vibrator including at least a piezoelectric substrate, an exciting electrode formed on one principal face of the piezoelectric substrate, and a bonding pad extending from the exciting electrode; and a flat plate-like printed circuit board which has a pad electrode for mounting of the piezoelectric vibrator and a grounding pad arranged on an upper face thereof, and has an external electrode on a lower face thereof, in which the piezoelectric vibrator is fixed to the upper face of the printed circuit board so as to be spaced from the printed circuit board by a predetermined gap by connecting the bonding pad and the pad electrode via a metal bump, wherein a metal layer having a thickness larger than an opening size of the gap is formed on a whole surface of an outer face of the piezoelectric device.

According to the invention described in claim 2, there is provided the piezoelectric device according to claim 1, further comprising a partition wall that is disposed in the gap to reduce the opening size of the gap and surrounds at least the vicinity of the exciting electrode.

According to the invention described in claim 3, there is provided the piezoelectric device according to claim 2, wherein the partition wall is formed on at least a peripheral edge of one principal face of the piezoelectric vibrator.

According to the invention described in claim 4, there is provided the piezoelectric device according to claim 2 or 3, wherein each side face of the piezoelectric vibrator and an outer end face of the partition wall corresponding to the each side face are substantially coincident with each other.

According to the invention described in claim 5, there is provided the piezoelectric device according to claim 2, wherein the partition wall is formed on an upper face of the printed circuit board corresponding to a peripheral edge of one principal face of the piezoelectric vibrator.

According to the invention described in claim 6, there is provided the piezoelectric device according to claim 3 or 4, wherein the bonding pad for grounding electrically conducts with the grounding pad via the partition wall and the metal layer, and the metal bump on the bonding pad for grounding is omitted.

According to the invention described in claim 7, there is provided the piezoelectric device according to any one of claims 2 to 6, wherein the partition wall is made from a photosensitive material.

According to the invention described in claim 8, there is provided the piezoelectric device according to any one of claims 2 to 6, wherein the partition wall is made from metal body.

According to the invention described in claim 9, there is provided the piezoelectric device according to any one of claims 1 to 8, wherein the metal layer is obtained by stacking a plurality of thin metal films.

According to the invention described in claim 10, there is provided the piezoelectric device according to any one of claims 1 to 9, wherein an upper face of the metal layer is covered with resin.

According to the invention described in claim 11, there is provided the piezoelectric device according to claim 10, wherein marking is conducted on an upper face of the resin.

### BRIEF DESCRIPTION OF THE DRAWINGS

Fig. 1 is a vertical sectional view showing a configuration of a surface acoustic wave device according to a first embodiment of the present invention;
Fig. 2 is a view for explaining a vertical section modeling a formation mechanism of a metal layer according to the present invention;
Fig. 3 is a vertical sectional view showing a configuration of a surface acoustic wave device according to a second embodiment of the present invention;
Fig. 4 is a partial vertical sectional view showing a configuration of a modification of the second embodiment;
Fig. 5 is a vertical sectional view showing a configuration of a surface acoustic wave device according to a third embodiment of the present invention;
Fig. 6 is a vertical sectional view showing a configuration of a surface acoustic wave device according to a fourth embodiment of the present invention;

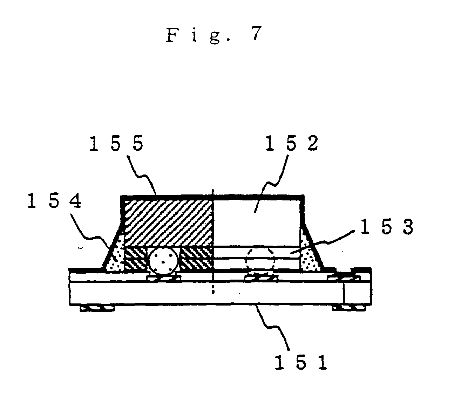

Fig. 7 is a vertical sectional view showing a configuration of a conventional surface acoustic wave device; and
Figs. 8(a) and 8(b) are views for explaining a method for manufacturing the conventional surface acoustic wave device.

### BEST MODE FOR CARRYING OUT THE INVENTION

The present invention will be explained in detail below based on the embodiments of the invention shown in the drawings.

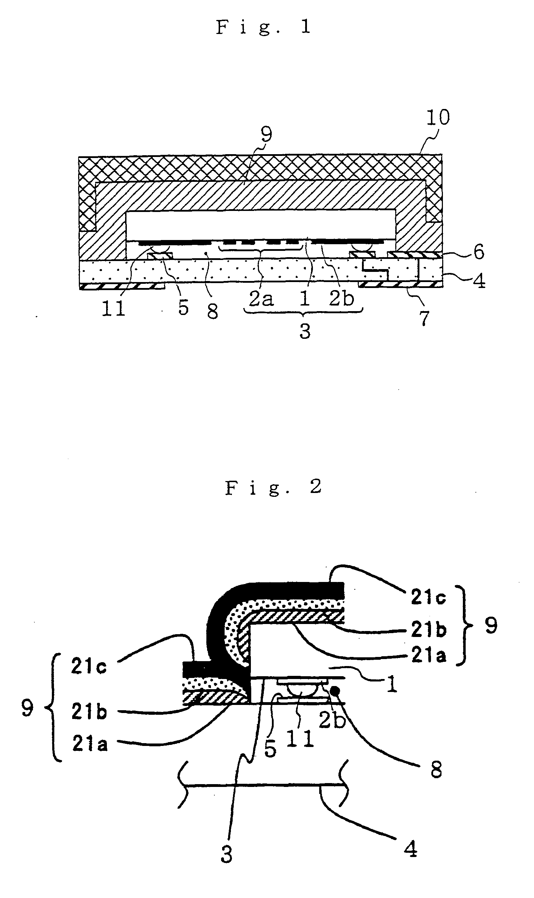

Fig. 1 is a vertical sectional view showing a configuration of a surface acoustic wave device serving as a piezoelectric device according to a first embodiment of the present invention.

The surface acoustic wave device according to the first embodiment is provided with a piezoelectric vibrator (hereinafter, "SAW chip") 3 including a piezoelectric substrate 1 made from, for example, LiTaO₃ (lithium tantalate), an exciting electrode (an interdigital electrode) 2a formed on one principal face (a lower face) of the piezoelectric substrate 1, and a bonding pad 2b extending from the exciting electrode 2a, and a flat plate-like printed circuit board 4 including pad electrodes 5 for mounting of the SAW chip 3 and a grounding pad 6 disposed on a upper face thereof and an external electrode 7 disposed on a lower face thereof. In order to electrically and mechanically fix the SAW chip 3 and the printed circuit board 4 to each other such that a lower face of the SAW chip 3 and an upper face of the printed circuit board 4 are spaced from each other by a predetermined gap 8 (flip-chip mounting), the SAW chip 3 is electrically connected to the pad electrodes 5 via metal bumps 11 fixed on the bonding pads 2b. A metal layer 9, for example, an aluminum layer larger (thicker) than a height size of the gap 8 is formed on a region from an upper face and four side faces of the SAW chip 3 to an upper face of the printed circuit board 4 which does not overlap with the SAW chip 3. Further, the grounding pad 6 disposed in a space which does not overlap with the SAW chip 3 on the upper face of the printed circuit board 4 and the metal layer 9 are put in an electrically conductive state (shielding effect can be obtained). In order to achieve reinforcement of mechanical fixation between the SAW chip 3 and the printed circuit board 4 and protection of the metal layer 9, it is desirable to coat a resin member 10 on an upper face of the metal layer 9. Marking may be conducted on an upper face of the resin member 10 such that an external electrode direction, rating, or the like of the surface acoustic wave device is visible.

The metal layer 9 is formed by a dry process (vacuum deposition, sputtering, or CVD process). That is, by forming a film within vacuum or inert gas atmosphere, a structure in which, while a state substantially coincident with atmosphere in a chamber of a dry process apparatus is being maintained in the gap 8, the gap 8 is sealed, can be achieved. Further, since the metal layer 9 has a high adhesiveness with the SAW chip 3 and the printed circuit board 4, namely, a high air-tightness, even if exposure to the atmosphere occurs at steps subsequent to the formation step of the metal layer 9, the atmosphere in the gap 8 is prevented from being replaced with the atmosphere.

Fig. 2 is a vertical sectional view modeling a formation mechanism of the metal layer according to the present invention.

In order to seal the gap 8 with the metal layer 9, namely, to cover a space (an opening of the gap 8) between a lower face peripheral edge of the SAW chip 3 and an upper face of the printed circuit board 4 opposed thereto with the metal layer 9, for example, in a case of the vacuum deposition, it is disposed such that an upper face of the SAW chip 3 becomes substantially orthogonal to a deposition source. Initially, a film (21a) is thinly formed on the SAW chip 3 and an upper face of the printed circuit board 4, a thicker layer (21b) is formed according to passage of time, and a layer (21c) covering the opening is finally formed. That is, a thick film (a thickness of 15 to 40 µm) thicker than the opening height (width) size of the gap 8 is formed.

The printed circuit board 4 is made from, for example, ceramic, and it is provided with pad electrodes 5 and a grounding pad 6 formed on an upper face thereof and a plurality of external electrodes (mounting electrodes) 7 formed on a lower face thereof. The pad electrodes 5, the grounding pad 6, and the external electrodes 7 are wired in a predetermined manner. Particularly, the external electrode connected to the grounding pad 6 serves as a grounding electrode.

According to the present invention, it is possible to implement mounting of the SAW chip 3 on the printed circuit board 4, formation of the metal layer 9, and formation of the resin member 10 by a batch process. That is, many surface acoustic wave devices can be manufactured by performing flip-chip mounting SAW chips 3 on respective pad electrodes on a pad electrode group and a grounding pad group divisionally formed on a printed circuit board base material with a large area, forming the metal layers 9 and the resin members 10 on mounting faces of the printed circuit board base material, namely, producing a set substrate on which a plurality of surface acoustic wave devices are provided continuously, and then individualizing the surface acoustic wave devices utilizing dicing. Therefore, productivity for a surface acoustic wave device can be improved.

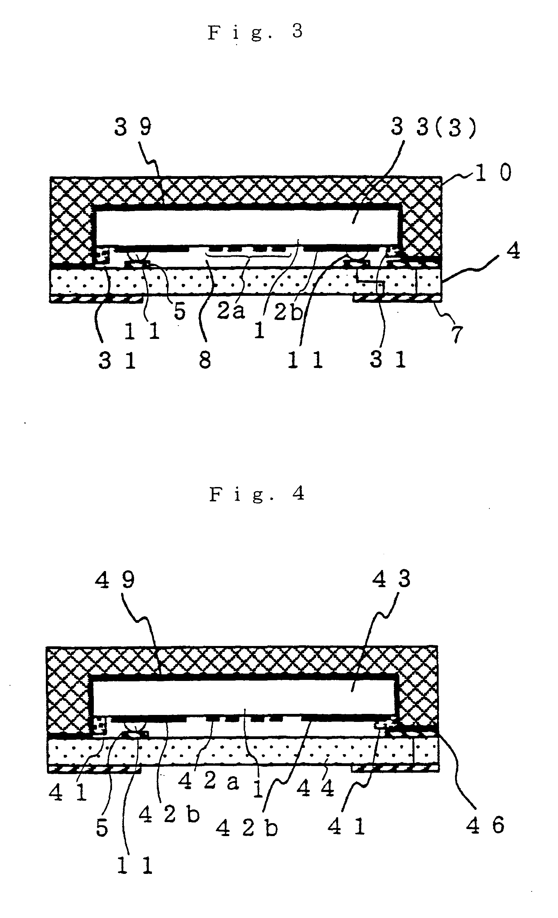

Fig. 3 is a vertical sectional view showing a configuration of a surface acoustic wave device serving as a piezoelectric device according to a second embodiment of the present invention.

A difference of the surface acoustic wave device according to the second embodiment from that according to the first embodiment lies in that a partition wall 31 for partially reducing the opening height (width) of the gap 8 is formed. The partition wall 31 surrounds the exciting electrode 2a and the bonding pads 2b. Preferably, by forming the partition wall 31 at a lower face peripheral edge of a SAW chip 33 (corresponding to the SAW chip 3 shown in Fig. 1) to reduce the opening height (width) of the gap 8 (which provides a clearance for preventing interference between a lower face of the partition wall 31 and an upper face of the printed circuit board 4 during flip-chip mounting of the SAW chip 33 and for performing replacement of atmospheres inside the partition wall 31 (below the exciting electrode)), the thickness of a metal layer 39 of the present embodiment can be made thinner than the metal layer 9 of the previous embodiment, which contributes to reductions of a forming time of the metal layer 39 and an amount of materials to be used for film forming.

In the forming process of the partition wall 31, it is desirable, in view of productivity, that a set of partition walls 31 surrounding exciting electrodes and respective bonding pad groups divisionally formed on one principal face of a large size piezoelectric substrate is formed by applying or printing insulating resin, coating inorganic materials (for example, silicon oxide) utilizing PVD or CVD, forming a metal film utilizing a plating process or a lift-off process, printing or applying electrically conductive paste, or applying similar processing so as to expose sections including the exciting electrode and the bonding pad groups. After the metal bumps 11 are formed on respective bonding pad groups, cutting is conducted at predetermined positions on the large size piezoelectric substrate so that (SAW chips 33 including) the partition walls 31 surrounding the exciting electrode and the bonding pads can be obtained.

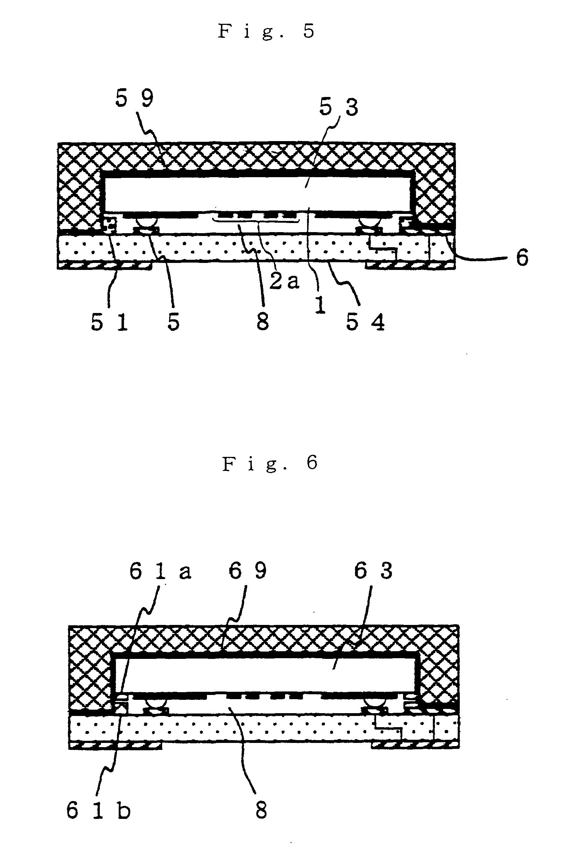

When the partition wall 31 is formed from an electrically conductive material, as shown in Fig. 4, a partition wall 41 is formed to extend inwardly so as to cover a portion of a grounding bonding pad 42b extending to a peripheral edge of the piezoelectric substrate and it is cut at a predetermined position. Thus, the partition wall 41 electrically conductive with the bonding pad 42b is put in an exposed state a side face of the SAW chip. When the SAW chip put in this state is mounted on the printed circuit board 44 and the SAW chip is sealed by a metal layer 49, the metal layer 49 is made electrically conductive with the bonding pad 42b and it is brought in contact with the partition wall 41 exposed to the side face of the SAW chip 43. Accordingly, the grounding pad 46 and the bonding pad 42b are made electrically conductive with each other via the partition wall 41. By exposing the partition wall 41 electrically connected to the bonding pad 42b to the side face of the SAW chip 43 and sealing the side wall with a metal film in this manner, the metal bump (11) for connecting to the bonding pad 42b and the pad electrode (5) to which the metal bump adheres become unnecessary, and the degree of freely designing the pattern for the SAW chip 43 and the printed circuit board 4 is improved, which is effective for further miniaturization of the surface acoustic wave device.

Fig. 5 is a vertical sectional view showing a configuration of a surface acoustic wave device serving as a piezoelectric device according to a third embodiment of the present invention.

A difference of the surface acoustic wave device according to the third embodiment from that according to the second embodiment lies in that a partition wall 51 for partially reducing the opening height (width) of the gap 8 is formed on an upper face of a printed circuit board 54. That is, by forming the partition wall 51 on an upper face of the printed circuit board 54 opposed to a lower face peripheral edge of the SAW chip 3 to reduce the opening height (width) of the gap 8 (which provides a clearance for preventing interference between a lower face of the partition wall 51 and an upper face of the printed circuit board 54 during flip-chip mounting of the SAW chip 3 and for performing replacement of atmospheres inside the partition wall 51 (below the exciting electrode)), a thickness of a metal layer 59 of the present embodiment can be made thinner than that of the metal layer 9 of the embodiment shown in Fig. 1, which contributes to reductions of a forming time and an amount of materials to be used for film forming. When the partition wall 51 is formed at a position where it comes in contact with either the pad electrode 5 or the grounding pad 6, it is desirable to dispose alumina coating or insulating resin. However, when the partition wall 51 is formed at a position where it does not come in contact with these members, it may be formed from an electrically conductive material.

Fig. 6 is a vertical sectional view showing a configuration of a surface acoustic wave device serving as a piezoelectric device according to a fourth embodiment of the present invention.

A difference of the surface acoustic wave device according to the fourth embodiment from those according to the second and the third embodiments lies in that partition walls for partially reducing the opening height (width) of the gap 8 are formed on a lower face peripheral edge of the SAW chip and an upper face of the printed circuit board opposed to the lower face peripheral edge. That is, by forming a partition wall 61a at a lower face peripheral edge of a SAW chip 63, and forming a partition wall 61b on an upper face of a printed circuit board 64 opposed to the partition wall 61a to reduce the opening height (width) of the gap 8 (which provides a clearance for preventing interference between a lower face of the partition wall 61a and an upper face of the partition wall 61b during flip-chip mounting of the SAW chip 63 and for performing replacement of atmospheres inside the partition walls 61a and 61b (below the exciting electrode)), a thickness of a metal layer 69 can be made thinner than that of the metal layer 9 shown in Fig. 1, which contributes to reductions of a forming time of the metal layer 69 and an amount of materials to be used for film forming. When the partition wall 61a is formed from an electrically conductive material, it is desirable to form the partition wall 61b from an insulating material.

The electrically conductive and insulating resins used for the partition walls 31, 51, 61a, and 61b may be thermosetting, thermoplastic, or photosensitive resin.

Although the present invention has been explained using the piezoelectric substrate made from lithium tantalate, the present invention can be applied to piezoelectric materials which can excite a surface acoustic wave, such as quartz, lithium tetraborate, lithium niobate, langasite, or the like, of course.

Although the present invention has been explained using the interdigital electrode as the exciting electrode, an electrode with a reflector may be used instead of the interdigital electrode. Although the present invention has been explained regarding the so-called SAW filter, a SAW resonator may be used.

The printed circuit board according to the present invention may be not only a ceramic circuit board, but also a resin board such as glass epoxy or silicon.

The piezoelectric device of the present invention has such a merit that with a simple manufacturing step, sealing for maintaining an atmosphere for an exciting electrode can be achieved in a piezoelectric device obtained from a packaging technique (CSP structure) pursuing size reduction and thinning.

## Claims

1. A piezoelectric device comprising: a piezoelectric vibrator including at least a piezoelectric substrate, an exciting electrode formed on one principal face of the piezoelectric substrate, and a bonding pad extending from the exciting electrode; and a flat plate-like printed circuit board which has a pad electrode for mounting of the piezoelectric vibrator and a grounding pad arranged on an upper face thereof, and has an external electrode on a lower face thereof, in which the piezoelectric vibrator is fixed to the upper face of the printed circuit board so as to be spaced from the printed circuit board by a predetermined gap by connecting the bonding pad and the pad electrode via a metal bump, wherein
a metal layer having a thickness larger than an opening size of the gap is formed on a whole surface of an outer face of the piezoelectric device.

2. The piezoelectric device according to claim 1, further comprising a partition wall that is disposed in the gap to reduce the opening size of the gap and surrounds at least the vicinity of the exciting electrode.

3. The piezoelectric device according to claim 2, wherein the partition wall is formed on at least a peripheral edge of one principal face of the piezoelectric vibrator.

4. The piezoelectric device according to claim 2 or 3, wherein each side face of the piezoelectric vibrator and an outer end face of the partition wall corresponding to the each side face are substantially coincident with each other.

5. The piezoelectric device according to claim 2, wherein the partition wall is formed on an upper face of the printed circuit board corresponding to a peripheral edge of one principal face of the piezoelectric vibrator.

6. The piezoelectric device according to claim 3 or 4, wherein the bonding pad for grounding electrically conducts with the grounding pad via the partition wall and the metal layer, and the metal bump on the bonding pad for grounding is omitted.

7. The piezoelectric device according to any one of claims 2 to 6, wherein the partition wall is made from a photosensitive material.

8. The piezoelectric device according to any one of claims 2 to 6, wherein the partition wall is made from metal body.

9. The piezoelectric device according to any one of claims 1 to 8, wherein the metal layer is obtained by stacking a plurality of thin metal films.

10. The piezoelectric device according to any one of claims 1 to 9, wherein an upper face of the metal layer is covered with resin.

11. The piezoelectric device according to claim 10, wherein marking is conducted on an upper face of the resin.
